# EUROPÄISCHE PATENTSCHRIFT

(11) **EP 3 769 595 B1**
(45) Veröffentlichungstag und Bekanntmachung des Hinweises auf die Patenterteilung: **25.03.2026**
(21) Anmeldenummer: 18807640.0
(22) Anmeldetag: 29.11.2018
(51) Int. Cl.: H05K 5/02, H02K 5/136, H02B 1/28, H01H 9/04

(54) **GEHÄUSE MIT INNERER DRUCKREDUZIERUNG**
HOUSING HAVING INTERNAL PRESSURE REDUCTION
BOÎTIER À RÉDUCTION DE PRESSION INTERNE

(30) Priorität: 22.03.2018 WO PCT/EP2018/057338
(43) Veröffentlichungstag der Anmeldung: 27.01.2021
(73) Patentinhaber: R. STAHL Schaltgeräte GmbH, 74638 Waldenburg (DE)
(72) Erfinder: LIMBACHER, Bernd, 74523 Schwäbisch Hall (DE); ARNHOLD, Thorsten, 74629 Pfedelbach (DE); HERMANOWSKI, Clife, 74743 Seckach (DE)
(74) Vertreter: Rüger Abel Patentanwälte PartGmbB
(86) Internationale Anmeldenummer: PCT/EP2018/083038
(87) Internationale Veröffentlichungsnummer: WO 2019/179646

(56) Entgegenhaltungen:
- DD-A3- 261 063
- DE-A1- 102009 025 296
- DE-A1- 102014 110 654
- DE-A1- 19 826 911
- DE-B3- 102014 206 433
- DE-U1- 202008 000 808
- DE-U1- 202015 005 015

## Beschreibung

Gegenstand der Erfindung ist ein explosionsgeschütztes Gehäuse, insbesondere ein ein- oder mehrkammeriges Gehäuse der Schutzart Ex-d.

In explosionsgefährdeten Bereichen werden häufig Gehäuse der Schutzart Ex-d eingesetzt. Solche Gehäuse sind so widerstandsfähig ausgebildet, dass sie einer in ihrem Innenraum stattfindenden Zündung eines explosiven Gasgemisches und der infolge der eintretenden Explosion darauf folgenden Druckerhöhung standhalten. Außerdem sind die Gehäuse so gestaltet, dass aus Ihnen keine Flammen oder glühende, als Zündquellen wirkende Partikel nach außen gelangen können. Sollten Spalte vorhanden sein, müssen diese eine Mindestlänge aufweisen und dürfen eine Höchstweite nicht überschreiten. Vorhandene Gehäuseöffnungen sind mit Druckentlastungskörpern versehen, die auch als Flammenschutzfilter bezeichnet werden und verhindern, dass eine im Gehäuse gezündete Flamme nach außen dringt und in der Umgebung vorhandenes explosionsfähiges Gemisch zündet, wobei sie andererseits einen Druckausgleich mit der Umgebung bewirken.

Die DD 261063 A3 beschreibt ein explosionsgeschütztes Gehäuse mit einem in seinem Innenraum angeordneten porösen Körper, beispielsweise aus Schlackenwolle, Glaswolle, Metall oder Keramik mit offenen durchgehenden Poren oder Spalten. Ein solcher in dem Gehäuse angeordneter Körper soll zu einer Senkung des Explosionsdrucks um ca. 90% führen.

Die DE 198 60 286 B4 offenbart ein für einen Bildschirm vorgesehenes Gehäuse, dessen Innenraum teilweise mit einem porösen Dämpfungsmaterial zur Senkung des Explosionsdrucks gefüllt ist. Das Material weist eine Vielzahl im Querschnitt kleiner, nicht geschlossener, sondern durchgehender Kanäle in Form von Poren oder Spalten auf. Der Explosionsdruck soll dadurch auf lediglich etwa 10 Prozent des Explosionsdrucks gemindert werden, das sonst in dem leeren Gehäuse auftreten würde.

Weiter schlägt die DE 10 2014 206433 B3 die Anordnung eines Tablett-Computers in einem mit einer Glasscheibe versehenen explosionssicheren Gehäuse vor, wobei in dem Tablett-Computer ein Dämpfungselement aus offenporiger Steinwolle, Quarzwolle, Glaswolle, Metallschaum oder dergleichen angeordnet ist.

Aus der DE 198 26 911 A1 ist ein Gehäuse der Bauart Druckfeste Kapselung bekannt, an dem konstruktionsbedingt Spalte vorhanden sind. Zum Schutz gegen Flammendurchschlag sind solche Spalte mit Dichtungen versehenen, die eine Kugelschüttung enthalten.

Aus der DE 10 2009 025 296 A1 ist ein explosionsgeschütztes Gehäuse bekannt, dessen Innenraum vollflächig mit stoßwellenabsorbierendem Material ausgekleidet ist. Das Material kann zum Beispiel eine metallische Wabenstruktur sein. Alernativ kann da Material bei Verwendung von einem porösen organischen Füllstoff und organischen Fasern zur Verstärkung verklebt mit Epoxidharz durch Aufsprühen an die Innenseite des Gehäuses aufgebracht sein.

Bei den bekannten Gehäusen mit Körpern aus offenporigem Material handelt es sich teilweise um Speziallösungen, die relativ raumgreifend sind und/oder sehr an die speziellen Gegebenheiten, wie beispielsweise Tablett-Computer, angepasst sind.

Die DE 10 2013 109 259 A1 beschreibt dagegen ein explosionsgeschütztes Gehäuse der Schutzart druckfeste Kapselung (Ex-d), in dessen Gehäusewand ein poröser Druckentlastungskörper vorgesehen ist, durch den ein im Gehäuse aufgebauter Explosionsdruck nach außen dringen kann. Dieses Prinzip nutzen auch die Gehäuse gemäß der US 4,180,177 sowie nach der DE 10 2010 016 782 B4.

Derartige Druckentlastungskörper unterliegen bei Anordnung solcher Gehäuse in widriger Umgebung der Verschmutzung oder bei Wetterbeaufschlagung der Verkeimung, Vereisung und/oder Korrosion. Die Berücksichtigung solcher Umstände führt zu einer Erhöhung des Aufwands.

Es ist Aufgabe der Erfindung, ein Konzept für ein explosionsgeschütztes Gehäuse anzugeben, das vielseitig anwendbar und wenig aufwendig ist.

Diese Aufgabe wird mit der Gehäuseanordnung nach Anspruch 1 gelöst:
Das erfindungsgemäße Gehäuse umfasst eine Wandanordnung mit mehreren Wänden, die einen Innenraum umschließen. Wenigstens zwei der Wände sind mit einem offenporigen Material versehen.

Mit dem offenporigen Material kann eine Kühlung und damit erhebliche Druckreduzierung des Gases in Folge einer Explosion erreicht werden.

Der das offenporige Material tragende Bereich der Wand kann eine Öffnung aufweisen, welche mit einem gasdurchlässigen flammendurchschlagsicheren Körper versehen ist. Die Begriffe flammendurchschlagsicher und zünddurchschlagsicher werden in dieser Anmeldung synonym verwendet. Ein flammendurchschlagsicherer oder zünddurchschlagsicherer Körper wird auch als Druckentlastungskörper bezeichnet.

In Ausführungsformen ist das offenporige Material vor dem flammendurchschlagsicheren Körper angeordnet, also zwischen dem Inneren des Gehäuses und dem flammendurchschlagsicheren Körper. Das offenporige Material sorgt für eine Kühlung des Gases im Falle des Auftretens einer Explosion, so dass das Gas den zünddurchschlagsicheren Körper gekühlt erreicht.

In bevorzugten Ausführungsformen ist der zünddurchschlagsichere Körper allein oder zumindest primär dazu ausgelegt, und besonders bevorzugt geprüft (Typ- und/oder Stückprüfung), Zünddurchschlagssicherheit zu gewährleisten, beispielsweise ausgelegt die Prüfung auf Zünddurchschlagssicherheit (z.B. für die Gruppe IIA, IIB oder IIC gemäß der Norm IEC/EN 60079-1) zu erfüllen. Der Körper ist also auf Grund des Spaltmaßes dazu eingerichtet auch ohne das vorgeschaltete offenporige Material dafür zu sorgen, dass heißes Gas oder Plasma, insbesondere Funken, beim Durchtritt durch die zünddurchschlagsicheren Spalte des Körpers soweit abkühlt bzw. verlöschen, so dass explosionsfähige Atmosphäre außerhalb des Innenraums durch das durch die Spalte hindurchtretende Gas oder Plasma nicht entzündet wird. In den Ausführungsformen kann jedoch mit dem zünddurchschlagsicheren Körper allein die Zieltemperaturklasse der Oberfläche des zünddurchschlagsicheren Körpers bzw. des Gehäuses noch nicht erreicht sein. Bevorzugt ist erst die Kombination aus offenporigem Material und zünddurchschlagsicherem Körper dazu eingerichtet, dass im Falle einer Explosion im Innenraum die Oberflächentemperatur des zünddurchschlagsicheren Körpers und/oder des Gehäuses unterhalb einer festgelegten maximalen Temperatur bleibt. In den Ausführungsformen ist erst die Anordnung mit dem offenporigen Material vor dem flammendurchschlagsicheren Körper dazu ausgelegt und bevorzugt geprüft (typ- oder stückgeprüft), die gewünschte Temperaturklasse (z.B. Klassen T1, T2, T3, T4, T5 oder T6 der Norm IEC/EN 60079-0) der Temperatur der Oberfläche des zünddurchschlagsicheren Körpers bzw. des Gehäuses zu erreichen. Bevorzugt ist das offenporige Material allein, also ohne die Kombination mit dem flammendurchschlagsicheren Körper, nicht zünddurchschlagsicher. Die hohen Anforderungen bzgl. des Spaltmaßes zur Verhinderung von Zünddurchschlag werden daher nur an den Körper, nicht aber das offenporige Material gestellt. Insbesondere kann das mittlere Verhältnis von Spaltweite zu Spaltlänge in dem flammendurchschlagsicheren Körper kleiner als in dem offenporigen Material sein.

Es ist auch möglich, dass der flammendurchschlagsichere Körper allein sowohl für Zünddurchschlagsicherheit als auch für das Einhalten eine Temperatur des Gehäuses bzw. des Körpers unterhalb einer festgelegten maximalen Temperatur ausgelegt und bevorzugt geprüft, insbesondere typ- oder stückgeprüft, ist. In solchen Ausführungsformen kann die Anordnung aus dem offenporigen Material und dem flammendurchschlagsicheren Körper dazu ausgelegt und bevorzugt geprüft, insbesondere typ- oder stückgeprüft sein, einer höheren, insbesondere nächsthöhere Temperaturklasse zu genügen. Je höher die Temperaturklasse (z.B. T1 bis T6 der Norm IEC/EN 60079-0), desto kleiner die maximal zulässige Oberflächentemperatur. Auch in diesen Ausführungsformen ist das offenporige Material allein bevorzugt nicht zünddurchschlagsicher.

Es ist alternativ oder zusätzlich möglich, dass der flammendurchschlagsichere Körper allein für Zünddurchschlagsicherheit einer bestimmten Gruppe(z.B. IIA oder IIB der Norm EN/IEC 60079-1) ausgelegt und geprüft, insbesondere typ- oder stückgeprüft, ist und dass die Anordnung mit offenporigem Material und dem flammendurchschlagsicheren Körper für eine höhere Gruppe bzgl. Zünddurchschlagsicherheit ausgelegt und bevorzugt geprüft, insbesondere typ- oder stückgeprüft, ist. Während der flammendurchschlagsichere Körper allein beispielsweise die Gruppe IIA erreicht, ist die Kombination aus offenporigem Material und flammendurchschlagsicheren Körper beispielsweise zum Erreichen der Gruppe IIB ausgelegt und geprüft, insbesondere typ- oder stückgeprüft. Alternativ kann beispielsweise eine Auslegung der Kombination für die Gruppe IIC ausgehend von der Gruppe IIA oder IIB für den flammendurchschlagsicheren Körper erreicht sein. Das offenporige Material allein ist vorzugsweise nicht ausgelegt, zünddurchschlagsicher zu sein.

In bevorzugten Ausführungsformen ertüchtigt das offenporige Material den flammendurchschlagsicheren Körper, so dass die Kombination einer strengeren Anforderung (niedrigere maximale Temperatur) an die maximale Oberflächentemperatur und/oder einer strengeren Anforderung an die oder einer höheren Klasse der Zünddurchschlagsicherheit genügt.
dem erfindungsgemäßen Konzept zum einfachen und modularen Aufbau eines offenporigen Materials ist das offenporige Material mit einem losen partikularen Material in einer Behälterstruktur gebildet. Die Behälterstruktur weist zumindest eine gasdurchlässige Begrenzungsstruktur auf, welche verschieden von einer Wand des Gehäuses ist, welche den Innenraum umschließt. Mittels der Begrenzungsstruktur wird ein Raum für das partikulare Material von dem Innenraum des Gehäuses abgeteilt. Die Begrenzungsstruktur kann beispielsweise von einer Gitteranordnung gebildet sein. Die Begrenzungsstruktur kann durch ein Gewebe oder ein Gelege gebildet sein. Der flammendurchschlagsichere Körper kann in Ausführungsformen einen Teil der Behälterstruktur bilden, indem der flammendurchschlagsichere Körper eine Barriere für das lose partikulare Material bildet. In andere Ausführungsformen sind die Begrenzungsstrukturen der Behälterstruktur gesondert von dem flammendurchschlagsicheren Körper.

Das lose partikulare Material kann beispielsweise Kugeln, insbesondere Hohlkugeln oder Kugeln, welche keinen Hohlraum umschließen, Granulat oder sonstiges Schüttgut umfassen. Die Partikel sind untereinander bevorzugt nicht stoffschlüssig verbunden, insbesondere nicht versintert, sondern außerhalb der Behälterstruktur gedacht relativ zueinander beweglich. Das partikulare Material ist vorzugsweise rieselfähig. In Ausführungsformen können die Partikel nicht ineinandergreifen und/oder sind miteinander unverschlungen. In anderen Ausführungsformen können Partikel vereinzelt gegenseitig ineinander greifen, bleiben jedoch insgesamt unzusammenhängend. Beispielsweise kann das lose partikulare Material Metallspäne und/oder Kunststoffspäne sein. In Ausführungsformen ist das lose partikulare Material frei von Fasern oder Faserabschnitten oder Streifen oder Streifenabschnitten.

Bevorzugt wird mittels der Behälterstruktur kein statischer Druck auf das lose partikulare Material ausgeübt. Bevorzugt ist das lose partikulare Material in der Behälterstruktur frei von statischem Druck abgesehen vom Schweredruck und dem statischen Atmosphärendruck.

Das lose partikulare Material kann eine auswählte mittlere Partikelgröße und/oder eine ausgewählte Größenverteilung der Partikel aufweisen. Insbesondere kann die Behälterstruktur eine gezielte Mischung verschieden größer Körper aufweisen.

Die Behälterstruktur kann eine maximale Menge, insbesondere bezogen auf die mittlere Partikelgröße und/oder die Größenverteilung des Schüttgutes, d.h. des losen partikularen Materials, fassen. Erfindungsgemäß enthält die Behälterstruktur weniger als die maximale Menge des losen partikularen Materials, der Füllgrad kann ist also kleiner 1.

Die Behälterstruktur kann wenigstens zwei Abteile aufweisen. Die Partikel eines Abteils können den Partikeln in einem anderen Abteil in Zusammensetzung, Form und/oder Größe gleichen oder unterschiedlich sein. Wenn sich die Schüttungen oder Füllungen, mit welchen die Abteile gefüllt sind, unterscheiden, beispielsweise hinsichtlich Partikelgröße, Partikelform, Material, Gesamtoberfläche der Partikel und/oder Gesamtwärmekapazität der Partikel und/oder Schüttgutdichte oder Füllgrad, kann durch Hintereinanderanordnung der Abteile der Kühlungs- und/oder des Druckentlastungseffektes des porösen Materials gegenüber einer Ausführungsform mit gleicher Füllung in den Abteilen oder nur einem Abteil optimiert sein. Das erste Abteil kann beispielsweise direkt der "Flammfront" ausgesetzt sein, also zwischen der Zündquelle und dem einen oder mehreren weiteren Abteilen angeordnet sein. Dieses erste Abteil kann beispielsweise bzgl. der Schüttgutdichte auf Umwandlung der kinetischen Energie optimiert sein, wobei die dahinter (nachgeschaltet) angeordnete Schüttung auf Kühlung optimiert ist. Die nachgeschaltete Schüttung kann beispielsweise eine im Vergleich zur Schüttung des ersten Abteils grö-ßere Oberfläche und/oder größere Wärmekapazität aufweisen und die Dichte des losen partikularen Materials in dem ersten Abteil kann größer sein als die Dichte des losen partikularen Materials in dem nachgeschalteten Abteil. Mit den speziellen Eigenschaften der "Schüttgutschichten" kann eine Verbesserung des Gesamtsystems "Druckentlastung" erreicht werden.

Das lose partikulare Material in der Behälterstruktur braucht keine Zünddurchschlagsicherheit zu gewährleisten. Es dient vornehmlich der Dämpfung eines Druckstoßes auf Grund einer Explosion und/oder der Kühlung von heißen Explosionsgasen. Wenn die Partikel gegeneinander beweglich sind, kann beispielsweise kinetische Energie auf die Partikel von einer Druckfront einer Explosion übertragen werden und die Energie kann durch Stöße und/oder Reibung von Partikel zu Partikel weitergegeben werden.

Erfindungsgemäß sind wenigstens zwei der Wände der Wandanordnung mit einem offenporigen Material versehen. Wenn an wenigstens zweien der Wände der Wandanordnung ein offenporiges Material angeordnet ist, kann durch die Anordnung des offenporigen Materials an zwei verschiedenen zum Beispiel einander gegenüberliegenden oder im Winkel zueinander stehenden Wänden, eine in dem Gehäuse ausgelöste Druckwelle besonders effizient vernichtet werden. Dies gilt sowohl, wenn jede der mit offenporigen Material versehenen Wände vollflächig mit diesem Material versehen ist, wie auch wenn sich bei einer oder mehreren der mit dem Material versehenen Wände das Material lediglich über einen Teilbereich der betroffenen Wand erstreckt.

Die Nutzung wenigstens zweier oder mehrerer Wandflächen zur Anbringung von offenporigem Material, das eine darauf auftreffende oder daran entlanglaufende Druckwelle dämpft, führt zu einer großen aktiven Dämpfungsfläche und somit zu einer hohen Dämpfungswirkung, auch wenn lediglich relativ dünne Lagen aus offenporigem Material verwendet werden, wobei die Dicke der Lage beispielsweise weniger als ein Zehntel oder ein Zwanzigstel des Gehäuseinnendurchmessers zwischen gegenüberliegenden Wänden betragen kann. Damit wird der für die Aufnahme von Komponenten zur Verfügung stehende Teil des Innenraums des Gehäuses durch das offenporige Material nur wenig reduziert. In dem Gehäuse können die Wände teilweise oder komplett mit offenporigem Material ausgekleidet sein. Die offenporigen Materialien wirken einerseits als ein nicht zündfähiges Entlastungsvolumen und andererseits als Löschvolumen für eine eindringende Flammenfront. Eine kugelförmige Explosionsfront wird durch die Auskleidung sofort schnellstmöglich großflächig aufgenommen, wobei eine Kühlung und Aufnahme unverbrannter Gase bewirkt wird. Damit wird zum einen die Menge des an der Verbrennung bzw. Explosion teilnehmenden Gases reduziert und andererseits durch Gaskühlung der Druck gemindert. Durch vollständige Auskleidung des Gehäuses innen mit dem offenporigen Material wird ein optimaler Flächen-/Volumen-Faktor für das Gehäuse erhalten.

Durch die Anordnung des offenporigen Materials, vorzugsweise ausschließlich an den Wänden, wird ein großer zusammenhängender Einbauraum für Betriebsmittel, Schalter und dergleichen erhalten.

Vorzugsweise ist das offenporige Material unmittelbar an den wenigstens zwei Wänden anliegend angeordnet. Die dadurch gegebene Wärmeübertragung zwischen dem offenporigen Material und der Gehäusewand kühlt das offenporige Material, so dass dieses einen hohen druckreduzierenden Effekt aufweist. Die Gehäusewand bildet ein an das offenporige Material thermisch angeschlossenen Wärmespeicher.

In nicht erfindungsgemässen Ausführungen kann das offenporige Material vollflächig, stoffschlüssig oder lediglich stellenweise stoffschlüssig mit den Wänden des druckfesten Gehäuses verbunden sein. Dazu kann das poröse Material mit den Wänden verschweißt oder, wenn das Gehäuse im Gussverfahren hergestellt wird, durch Einbringen in die Gussform durch Urformen mit den Gehäusewänden verbunden sein. Andere mechanische form- und/oder stoffschlüssige Verbindungsmöglichkeiten können genutzt werden. Beispielsweise kann das offenporige Material von einer Gitterstruktur eingefasst sein, die mit der Wandanordnung verbunden ist. Die Gitterstruktur kann ein Drahtgitter, ein Lochblech, ein Kunststoffgitter oder dergleichen sein.

Das offenporige Material kann an jeder der Wände, an denen es angebracht ist, eine wandabgewandte Fläche aufweisen, die dem Innenraum zugewandt ist. Die wandabgewandte Fläche kann parallel zu der Wand oder im spitzen Winkel zu dieser verlaufend angeordnet sein. In nicht erfindungsgemässen Ausführungen kann das poröse Material als Platte oder Matte oder Füllung im Wesentlichen gleichbleibender Dicke ausgebildet sein, so dass die wandabgewandte Fläche parallel oder im spitzen Winkel zu der Wand verlaufend angeordnet ist. Damit stehen sich im Innenraum wenigstens zwei Flächen des offenporigen Materials im Wesentlichen gegenüber oder im Winkel zueinander. Beides führt zu einer wirksamen Dämpfung einer dynamisch durchlaufenden Flammenfront.

An von offenporigem Material freien Stellen der Wand oder an von offenporigem Material bedeckten Stellen der Wand können Druckentlastungskörper angeordnet sein. Während das offenporige Material selbst keine Sicherheit gegen Flammendurchschlag bietet oder bieten muss, wird die Flammendurchschlagsicherheit nach außen durch den oder die Druckentlastungskörper erbracht. Das offenporige Material dient in erster Linie der Gaskühlung und somit der Aufnahme von Wärmeenergie und der Minderung von Druckspitzen. Hinsichtlich der Gasströmung sind von dem offenporigen Material gebildete Wärmeaufnahmeeinrichtung und die Flammendurchschlagsicherung hintereinander angeordnet. Durch die Kombination des nichtflammendurchschlagsicheren Materials mit einer Flammendurchschlagsicherung wird eine Druckentlastung mit verbesserter Wirksamkeit geschaffen. Dies gilt unabhängig davon, ob das offenporige Material nur an der Innenseite einer einzigen Gehäusewand oder an mehreren Gehäusewänden angebracht ist.

Bei einer bevorzugten Ausführungsform kann jedoch auf Druckentlastungskörper und somit einen äußeren Druckausgleich verzichtet werden, indem das innen an den Wänden angebrachte offenporige Material zu einer schnellen Kühlung und somit zu ganz erheblichen Druckreduktion führt. In verschiedenen nicht anspruchsgemässen Ausführugnen kann das offenporige Material durch einen oder mehrere Körper aus Metallschaum, aus gesinterten Metallpartikeln, Metallfasern, insbesondere Edelstahlwolle, andere Metallfasern, Metall-Drähten, Metall-Streifen, mineralischen Fasern wie Glasfasern, Steinwollfasern, Quarzfasern und ähnlichem gebildet sein. Das offenporige Material kann eine Gitterstruktur, einen Maschenstruktur oder eine Gewebestruktur aufweisen und insbesondere aus mehreren, aufeinander liegenden Lagen der Gitter-, Maschen- oder Gewebestruktur gebildet sein. Diese können lose aufeinander liegen oder, in Ausführungen, die nicht der beanspruchten Erfindung entsprechen, z.B. durch Sintern oder durch eine andere Technik, miteinander verbunden sein. Bei den Körpern aus Draht- oder Fasermaterial kann es sich um nadelgefilzte Anordnungen, d.h. ein Wirrfasergelege mit verfilzten, stofflich jedoch nicht aneinander gebundenen Fasern handeln. Bedarfsweise kann auch eine stoffliche Bindung der Fasern untereinander, z.B. durch ein Bindemittel oder durch Sintern vorhanden sein. Die Fasern führen zu einer Kühlung der aufgenommenen Druckwelle durch Wärmeaufnahme und zu einer Vernichtung der kinetischen Energie der Druckwelle durch innere Reibung der Fasern aneinander. Bevorzugt wird ein Material mit hoher Wärmespeicherkapazität, wie Steinwolle oder Keramikwolle.

In Ausführungen, die nicht der beanspruchten Erfindung entsprechen, kann das Fasermaterial des offenporigen Materials zu einem Körper in Gestalt von Platten, Quadern oder anderen Formen vorgepresst sein, die in das Gehäuse eingelegt, eingeklebt oder eingeschraubt werden können oder die durch ein Gestell gehalten sind. Die Verdichtung des Faserkörpers ist jedoch vorzugsweise so schwach, dass Abstände und Spalte der porösen Materialen wenigstens an einigen Stellen oberhalb der Grenzspaltenweite des klassischen Explosionsschutzes liegen, d.h. Kühlungseffekt, Strömungseffekt oder sonstige kinetische Effekte, die eine Zündung von in dem Material vorhandenem Gas oder ein Durchlaufen der Flammenfront durch das Material verhindern könnten, sind nicht oder nicht durchgängig vorhanden. Insbesondere wenn das offenporige Material eine hohe Wärmekapazität aufweist, wie es beispielsweise bei Glasfasern, Quarzfasern, Keramikfasern, Steinfasern der Fall ist, wird dennoch eine hohe Druckreduktion erreicht.

In Ausführungen, die nicht der beanspruchten Erfindung entsprechen, kann das offenporige Material auch durch anorganische oder organische Bindemittel soweit gebunden sein, dass ein offenporiger formstabiler Körper entsteht. Dieser muss nicht zwangsläufig an die Wand anschließen. Erfindungsgemäss ist ein offenporiger formstabiler Körper aus einer Behälterstruktur, welche teilweise mit losem partikularem Material gefüllt ist, gebildet.

Ein solcher ein Schüttgut enthaltener Körper kann auch in dem Gehäuse von vier, fünf oder sechs Seiten zugänglich angeordnet sein. Er wirkt auch ohne Wandanschluss druckmindernd und kann alternativ oder zusätzlich zu den vorstehend beschriebenen Auskleidungen des Gehäuses mit offenporigem Material Anwendung finden. Das lose partikulare Material in der Behälterstruktur an der Wand oder in dem Innenraum zeichnet sich gerade dadurch aus, dass die Partikel untereinander nicht stoffschlüssig verbunden sind, um einen offenporigen Körper mit einer großen Oberfläche zu erhalten. Die Behälterstruktur kann beispielsweise ein Quader oder ein Würfel oder ein sonstiger dreidimensionaler Körper sein, in welchem das Schüttgut untergebracht ist.

Mittels eines nicht beanspruchten Verfahrens kann eine Anordnung aus einem porösen Material und einem flammendurchschlagsicheren Körper bereitgestellt werden. Der flammendurchschlagsichere Körper ist unabhängig von dem porösen Material für eine bestimmte Gasgruppe bzgl. des Vermeidens von Zünddurchschlag ausgelegt und bevorzugt geprüft. Beispielsweise gemäß einer der Gruppen IIA, IIB, IIC gemäß der Norm EN/IEC 60079-1. Zum Sicherstellen des Einhaltens eine Obergrenze der Temperatur des flammendurchschlagsicheren Körpers und/oder eines Gehäuses, welches mit dem Körper versehen wird, wird aber die Anordnung des porösen Materials und des Körpers ausgelegt.

In einem weiteren nicht beanspruchten Verfahren zum Bereitstellen einer Vorrichtung mit einer erhöhten Zünddurchschlagsicherheit wird offenporiges Material an einem Körper angeordnet, welcher Körper für Zünddurchschlagsicherheit einer bestimmten Gruppe ausgelegt und vorzugsweise typgeprüft oder stückgeprüft ist, wobei die durch das Anordnen entstehende Anordnung aus zünddurchschlagsicherem Material und offenporigem Material für eine höhere Zünddurchschlagsicherheitsstufe ausgelegt ist, als der zünddurchschlagsichere Körper.

Weitere Merkmale und Ausführungsbeispiele der Erfindung ergeben sich aus den Ansprüchen, der Zeichnung und der nachfolgenden Beschreibung. Es zeigen:
Figur 1 ein erfindungsgemäßes Gehäuse mit verschiedenen Maßnahmen zur Druckreduktion, in schematisierter Darstellung;
Figur 2 einen Ausschnitt aus einem druckreduzierenden offenporigen Körper des Gehäuses nach Figur 1;
Figur 3a und 4 weitere Ausführungsformen des erfindungsgemäßen Gehäuses jeweils, in schematisierter Querschnittsdarstellung,
Figur 3b einen Ausschnitt aus einem offenporigem Material des Gehäuses gemäß Figur 3a.
Figur 5a eine weitere Ausführungsform eines erfindungsgemäßen Gehäuses,
Figur 5b ein Ausschnitt aus dem Gehäuse gemäß Figur 5a,
Figur 6 ein Ausschnitt aus einem Gehäuses in einer weiteren Ausführungsform,
Figur 7 ein Ausschnitt aus einem Gehäuse in einer zu Figur 7 abgewandelten Ausführungsform,
Figur 8 ein Ausschnitt aus einem Gehäuse in einer weiteren Ausführungsform,
Figur 9 ein Ausschnitt aus einem Gehäuse einer noch weiteren Ausführungsform,
Figur 10 einen Ausschnitt aus einem druckreduzierenden offenporigen Körper des Gehäuses nach Figur 9 und
Figur 11 ein Diagramm zur Veranschaulichung von Verfahren.

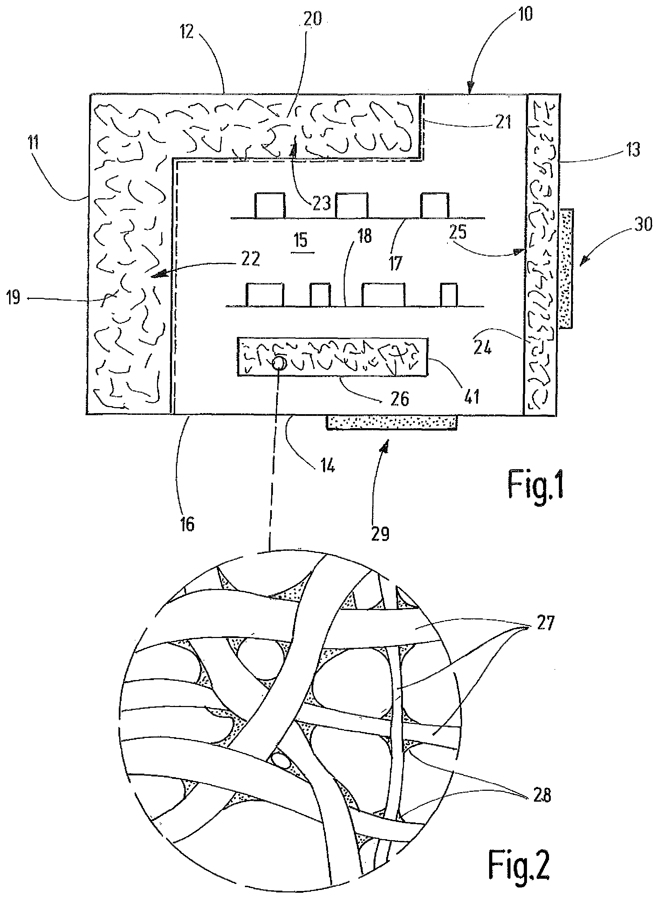

In Figur 1 ist ein explosionsgeschütztes Gehäuse 10 veranschaulicht, das mehrere Wänden 11, 12, 13, 14 umfasst, die einen nach außen abgeschlossenen Innenraum 15 umgrenzen. Die Wände 11 bis 14 bilden zusammen mit einem nicht weiter veranschaulichten Boden und einem Deckel eine Wandanordnung 16. Boden und Deckel diese Gehäuses können mit den Wänden 11 bis 14 fest oder auch lösbar verbunden sein. Sie werden weiterhin ebenfalls als Wände angesehen.

In dem Innenraum 15 können Bauelemente und Komponenten wie beispielsweise Leiterplatten, 17, 18 mit darauf angeordneten elektrischen Bauelementen angeordnet sein, die Zündquellen bilden können.

An wenigstens zwei Wänden 11, 12 des Gehäuses 10 ist offenporiges Material 19, 20 zum Beispiel in Gestalt von Platten, Körpern oder Matten angeordnet, das die jeweilige Wand 11, 12 jeweils ganz oder teilweise bedeckt. Das offenporige Material umfasst Partikel in beweglicher Form. Es kann regelmäßig oder unregelmäßig ausgebildete und angeordnete Poren enthalten. In nicht beanspruchten Ausführungen kann es sich um Gitterstrukturen mit einem oder mehreren übereinanderliegenden Gittern aus Metalldrähten, Seilen oder Streifen handeln, die gitterförmig oder als Gewebe angeordnet sind. Die Metalldrähte, - Seile, oder -Streifen sind untereinander verbunden oder sie liegen lose bspw. lagenweise aufeinander. Die MetallDrähte, -streifen oder -Drähte können auch zu einer anderweitige Maschenware, wie z.B. zu einem Gestrick oder Geflecht geformt sein. Die Drähte, Seile oder Streifen können auch aus einem anderen wärmeabsorbierenden Material bestehen.

In nicht beanspruchten Ausführungen ist das offenporige Material dabei vorzugsweise unmittelbar an die jeweilige Wand 11, 12 anliegend angeordnet und weiter vorzugsweise mit dieser verbunden. Die Verbindung kann durch vollflächiges Verkleben, Verschweißen oder durch andere Verbindungsmaßnahmen, erfolgen, die zu einer stoffschlüssigen teil- oder vollflächigen Verbindung führen. Erfindungsgemäss ist das offenporige Material 19, 20 in einer Aufnahme gehalten, die beispielsweise durch eine Gitterstruktur 21 gebildet ist. Die Gitterstruktur 21 kann ein Lochblechgehäuse, ein Drahtgitter, ein Käfig oder dergleichen sein, der mit dem Gehäuse 10 verbunden ist und das offenporige Material 19, 20 von dem sonstigen Innenraum 15 fernhält. Um ein offenporiges Material zu bilden, ist die Gitterstruktur 21 mit losem partikularem Material gefüllt, wobei der Füllgrad weniger als 1 beträgt. Ein hoher Füllgrad kann beispielsweise in Ausführungsform erforderlich sein, in welchen das offenporige Material vor einem Druckentlastungskörper angeordnet ist, um sicherzustellen, dass Gas einer Explosionsfront in jedem Fall zunächst durch das offenporige Material treten muss, um zu einem Druckentlastungskörper zu gelangen. Ein niedrigerer Füllgrad kann für ein offenporiges Material ausreichen, welches an einem geschlossenen Bereich einer Wand angeordnet ist oder im Innenraum von einer, zwei, ..., oder sechs Seiten zugänglich. Das lose partikulare Material kann regelmäßig, beispielsweise kugelförmige, oder unregelmäßig, beispielsweise Sandkörner, Körper umfassen. Das lose partikulare Material ist vorzugsweise nicht entflammbar. Als geeignete schüttbare Körper können beispielsweise Glaskugeln, Hohlglaskugeln, Metallkugeln, Metallkugeln, Keramikkugeln, Polymergranulat, Blähgranulat, Schaumkugeln/-körper, Faserkugeln-, -körper oder sonstige Schüttungen verwendet werden. In Ausführungsformen kann die mit der Gitterstruktur 21 gebildete Behälterstruktur mit Späne als loses partikulares Material gefüllt sein. Die Gitterstruktur folgt den Wänden 11 und 12 und ist damit über Eck angeordnet. Allgemein kann die Gitterstruktur der Gehäuseform und/oder Wandform des Gehäuse angepasst sein, z.B. entlang der Wand konstanten Abstand zu der Wand 11, 12 aufweisen.

Das offenporige Material 19, 20 weist an seiner jeweils zu dem Innenraum 15 hin weisenden Seite Flächen 22, 23 auf, die wie dargestellt in einem Winkel zueinander angeordnet sind, der kleiner als 180° ist.

Alternativ oder zusätzlich zu dem offenporigen Material 20 ist dem offenporigen Material 19 gegenüberliegend ein weiterer Abschnitt 24 offenporigen Materials angeordnet. Dieses kann das gleiche oder ein anderes offenporiges Material wie die Materialien 19, 20 sein. Es kann die gleiche oder eine unterschiedliche Dicke aufweisen. Ebenso können die offenporigen Materialien 19, 20 gleiche oder unterschiedliche Dicken aufweisen. Das Material 24 weist eine dem Innenraum 15 zugewandte Fläche 25 auf, die der Fläche 22 gegenüberliegt und die zu der Fläche 23 im Winkel von z.B. 90° angeordnet ist.

Das offenporige Material 19, 20 und/oder 24 bildet eine innere Druckentlastungsvorrichtung. Eine zusätzliche oder alternative innere Druckentlastungsvorrichtung kann durch einen offenporigen Körper 26 gebildet sein, der an wenigstens vier, vorzugsweise an fünf oder sechs Seiten frei, d.h. nicht an einer der Wände der Wandanordnung anliegend, in dem Innenraum 15 des Gehäuses 10 angeordnet ist. Die nachfolgenden Erläuterungen des Körpers 26 gelten optional auch für das offenporige Material 19, 20.

In einer nicht erfindungsgemässen Ausführung ist der offenporige Körper 26 ein Faserkörper, dessen Fasern durch ein Bindemittel untereinander verbunden sind. Figur 2 veranschaulicht schematisiert einen Ausschnitt aus dem Körper 26. Wie ersichtlich sind mehrere Fasern 27 in räumlich ungeordneter Anordnung miteinander verschlungen und an wenigstens einigen ihrer Kreuzungsstellen durch Bindemittel 28 verbunden. Bei den Fasern kann es sich um Metallfasern oder mineralische Fasern insbesondere Glasfasern, Quarzfasern, Steinfasern, Keramikfasern, handeln. Das Bindemittel 28 kann ein Kunstharz, insbesondere ein Phenolharz, sein. Der Harzanteil ist so gering, dass die zwischen den Fasern 27 vorhandenen Poren offen bleiben. Er ist jedoch so groß, dass der offenporige Körper 26 eine erhebliche Formstabilität hat, so dass er bei Zündung einer Explosion in dem Innenraum 15 nicht aufgelöst wird und möglichst keine oder allenfalls ein unschädliches Quantum Fasern freisetzt.

Alternativ können die Fasern, Drähte, Fäden oder Partikel, aus denen der Körper 26 besteht, auch regelmäßig angeordnet und dennoch mit einem Bindemittel untereinander verbunden sein. Bei den Fasern 27 kann es sich um die gleichen Fasern handeln, die auch für das offenporige Material 19, 20, 24 Anwendung findet. Dieses kann ebenfalls vorverdichtet und, falls gewünscht, auch mit Bindemittel versehen sein.

Erfindungsgemäss ist der Körper 26 durch eine Behälterstruktur gebildet, welche mit losem partikularem Material teilweise gefüllt ist. Die gasdurchlässige Begrenzungsstruktur der Behälterstruktur trennt ein Abteil des Innenraums für die Füllung aus losem partikularem Material ab. Damit kann beispielsweise eine Kugelschüttung an einem beliebigen Ort in dem Gehäuse plaziert werden. Das lose partikulare Material kann beispielsweise Quarzsand oder Glaspartikel sein. Der Körper ist vorzugsweise frei von elektrischen Betriebsmitteln, insbesondere frei von elektrischen Bauteilen. Der Körper selbst weist Spalte auf, welche nicht zünddurchschlagsicher sein zu brauchen. Die Spalte gebildet durch Öffnungen in der Behälterstruktur sowie Zwischenräumen zwischen Partikeln der Füllung aus losem partikularen Material müssen kein Normmaß aufweisen, so dass Zünddurchschlagsicherheit durch die Spalte sichergestellt ist. Der Körper dient allein dem Druckabbau bei einer auftretenden Explosion im Innenraum des Gehäuses. Das Gehäuse braucht der Zündschutzart "Sandkapselung" (Ex-q, gemäß der Norm IEC 60079-5) nicht zu entsprechen. In dem Körper 26 können sich die losen Partikel auf Grund des Füllgrades noch gegeneinander bewegen oder die Behälterstruktur 41 ist derart voll mit losen Partikeln, so dass sich diese nicht gegeneinander bewegen können.

Optional kann das Gehäuse 10 mit wenigstens einer Druckentlastungsvorrichtung 29 und/oder 30 versehen sein, die eine Strömungsverbindung zwischen dem Gehäuseinnenraum und der Umgebung ermöglicht. Beide Druckentlastungsvorrichtungen 29, 30 sind poröse gasdurchlässige Körper mit einer Spaltweite und Spaltlänge, die einen Flammendurchschlag (Zünddurchschlag) verhindert. Die Druckentlastungsvorrichtung 29 ist in einem von offenporigem Material freien Abschnitt der Wand 14 des Gehäuses 10 angeordnet. Die zusätzlich oder alternativ vorgesehene Druckentlastungsvorrichtung 30 ist von dem Innenraum 15 her gesehen durch das offenporige Material 25 bedeckt. Dieses hindert den Gasdurchtritt jedoch nicht. Diese Kombination aus wärmeaufnehmendem offenporigen, jedoch nicht flammendurchschlagsicherem Material 25 und der Druckentlastungsvorrichtung 30 kann unabhängig von dem offenporigen Material 19, 20 Anwendung finden.

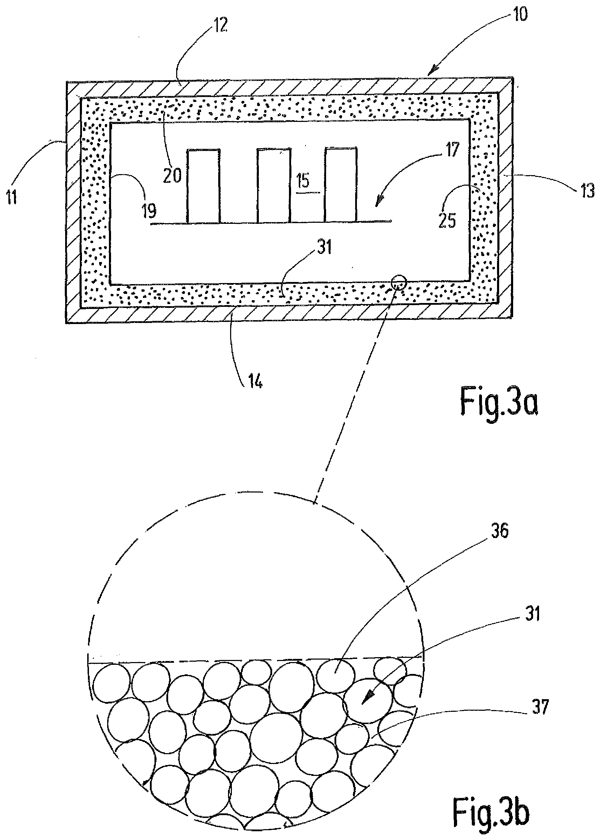

Figur 3a veranschaulicht eine abgewandelte Ausführungsform des erfindungsgemäßen Gehäuses 10. Die vorige Beschreibung gilt unter Verwendung der bereits eingeführten Bezugszeichen entsprechend. Im Unterschied zu dem zuvor beschriebenen Gehäuses 10 weist das Gehäuse 10 nach Figur 3 poröses Material 19, 20, 25, 31 an allen vier Wänden 11, 12, 13, 14 des Gehäuses und optional zusätzlich an dem nicht veranschaulichten Boden und/oder dem Deckel auf. Das offenporige Material 19, 20, 25, 31 bildet eine an den Wänden entlang führende lokal unterbrochener oder auch ununterbrochene Schicht, die eine in dem Innenraum 15 gezündete Flammenfront auffängt und die entstehende Druckwelle absorbiert.

Figur 3a veranschaulicht, eine Ausführungsform des offenporigen Materials 31 als Behälterstruktur, welche durch die Wände 11, 12, 13, 14 und eine temperaturstabile zusätzliche Begrenzungsstruktur 21 gebildet ist und welche ein loses partikulares Material 39 enthält, wobei zusammenhängende Freiräume zwischen den Partikeln offene Poren 40 bilden und damit dem Material 31 die Fähigkeit zum Gasdurchlass in das Innere des Materials 31 und/oder durch das Material 31 hindurch verleihen. Die Partikel 39 in dem offenporigen Material 31 einer beliebigen Ausführungsform können eine einheitliche Größe oder, wie dargestellt, unterschiedliche Durchmesser aufweisen. Die Partikel 39 können eine ausgewählte Größenverteilung aufweisen, welche sich von einer Größenverteilung mit einheitlicher Größe unterscheidet.

Die zusätzliche Begrenzungsstruktur 21 kann beispielsweise eine Gitterstruktur in Form eine Drahtgitters, Lochblechs, eines Kunststoffgitters oder dergleichen sein. Eine zusätzliche Begrenzungsstruktur 21 in Form eines Gewebes kann Verwendung finden. Unabhängig von der konkreten Ausführungsform gewährleistet die Behälterstruktur des porösen Materials aus Wänden 11 - 14 und Begrenzungsstruktur 21 eine vorzugsweise eine Durchströmung des offenporigen Materials 31 mit Gas durch die Poren. Gleichzeitig sind Öffnungsweiten der Behälterstruktur so klein, dass das darin enthaltene Schüttgut, d.h. das lose partikulare Material, innerhalb der Behälterstruktur bleibt. Bevorzugt ist das Schüttgut abriebfest, so dass beim bestimmungsgemäßen Gebrauch - abgesehen von dem Fall einer Explosion im Innenraum - durch Reibung der Partikel 39 aneinander kein Staub oder kleinere Partikel (Reibpartikel) entstehen können. Alternativ ist oder zusätzlich ist die Behälterstruktur staubdicht oder reibpartikeldicht.

Die Partikel sind bei den dynamischen Drücken, welche bei einer Explosion, für welche das Gehäuse bzw. die Anordnung ausgelegt wird, auftreten, vorzugsweise inkompressibel. Gegenüber einem kompressiblen offenporigen Material, beispielsweise einem Wirrfaserkörper, kann dies den Vorteil haben, dass die Zwischenräume zwischen den Partikeln beim Auftreffen einer Druckfront auf das offenporige Material offen bleiben, während bei einem elastisch nachgiebigem offenporige Material die Gefahr besteht, dass gerade dann, wenn die Druckfront auf das Material auftrifft, die Poren dadurch geschlossen werden und der Gasaustausch durch das Material beeinträchtigt wird.

Die untereinander nicht verbundenen Partikel weisen zudem eine besonders große Oberfläche auf, was die Kühlung mittels eines offenporigen Materials aus einer Behälterstruktur mit darin enthaltenen losem partikularem Material besonders effektiv macht. Gegeneinander frei bewegliche Partikel in einer Behälterstruktur, welche mit einem Füllgrad kleiner 1 gefüllt ist, bietet zudem die Möglichkeit Wärme und/oder Druck in kinetische Energie der Partikel umzuwandeln, und dadurch eine besonders effektive Kühlung und/oder Druckreduzierung. In einer nicht anspruchsgemässen Alternative kann die Behälterstruktur 41 eines offenporigen Körpers (z.B. Körper 26 in Figur 1) bzw. offenporigen Materials derart gefüllt sein, dass sich die Partikel gegeneinander nicht bewegen können.

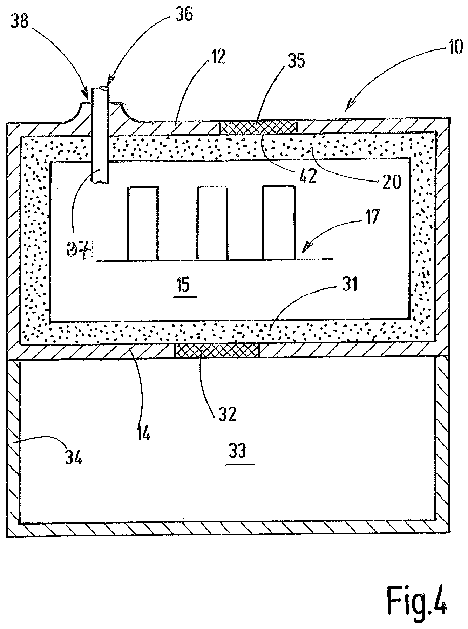

Bei dem in Figur 4 veranschaulichten Gehäuse 10 handelt es sich um eine auf dem Gehäuse 10 nach Figur 3a aufbauende Ausführungsform. Optional weist dieses Gehäuse 10 eine Druckentlastungsvorrichtung 32 auf, die flammendurchschlagsicher ausgebildet und in der Wand 14 angeordnet ist, an die sich ein Expansionsvolumen 33 anschließt. Dieses kann durch ein Teilgehäuse 34 von der Umgebung getrennt und gegen diese abgeschlossen sein oder auch Öffnungen aufweisen, über die es mit der Umgebung in Verbindung steht. Die Ausführungsform gemäß Figur 4 weist als offenporiges Material eine Behälterstruktur enthaltend loses partikulares Material auf, wie beispielsweise im Zusammenhang mit Figur 3 beschrieben.

Zusätzlich oder alternativ kann in der Wand 12 ein Druckentlastungskörper 35 vorgesehen sein, der eine Druckentlastung zur Umgebung hin ermöglicht. Der flammendurchschlagsichere Druckentlastungskörper 35 kann innen wiederum von dem porösen Material 20 überdeckt sein oder freiliegen. Insbesondere kann der Druckentlastungskörper 35 von losem partikularem Material in einer Behälterstruktur überdeckt sein. Der Druckentlastungskörper selbst kann ein Teil der Behälterstruktur sein. Alternativ kann zwischen dem Druckentlastungskörper und dem losen partikularen Material eine gasdurchlässige weitere Begrenzungsstruktur 42, beispielsweise ein Gitter, angeordnet sein. Die zusätzliche Begrenzungsstruktur kann mit dem Druckentlastungskörper 35 verbunden oder unverbunden sein. Außerdem kann eine Durchführungseinrichtung 36 vorgesehen sein, indem beispielsweise eine Welle 37 durch die Gehäusewand 12 geführt ist. Dazu kann die Welle 37 mit der Gehäusewand 12 einen zünddurchschlagsicheren Spalt 38 festlegen. Die Welle 37 kann durch das offenporige Material 20 geführt sein und Bewegungen zwischen Elementen außerhalb des Gehäuses 10 zu Elementen innerhalb des Gehäuses 10 übertragen.

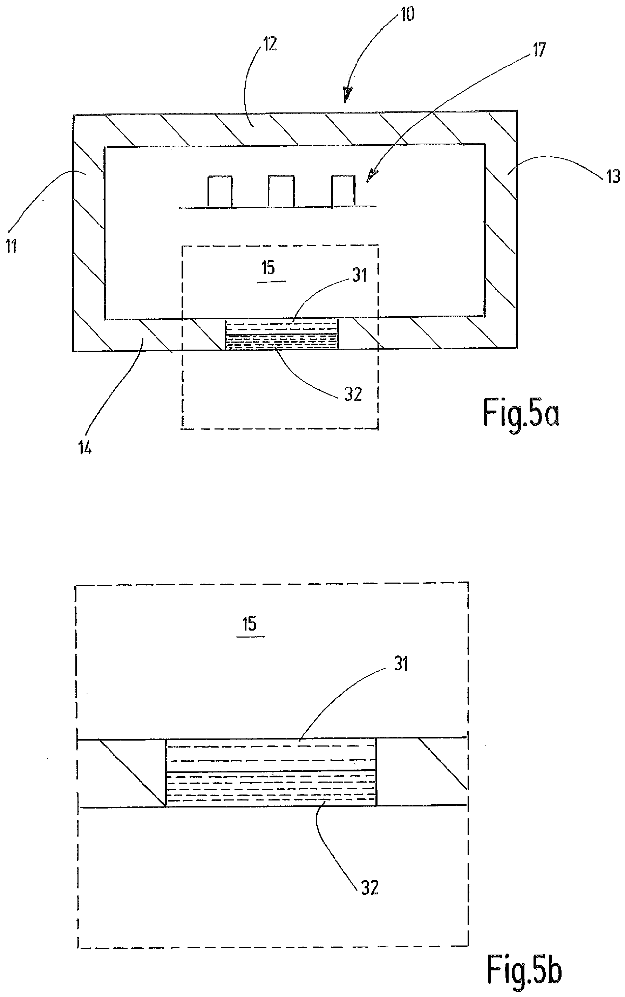

Figur 5a zeigt eine Ausführungsform eines nicht erfindungsgemäßen Gehäuses 10 mit einem darin befindlichen elektrischen Betriebsmittel 17. Wie dargestellt ist nur eine Wand 14 des Gehäuses mit einem gasdurchlässigen porösen Material 31 versehen, in dem dieses ganz (wie dargestellt) oder teilweise (in den Innenraum 15 des Gehäuses 10 überstehend) in einer Öffnung der Wand 14 des Gehäuses angeordnet ist (s. auch die vergrößerte Darstellung des in Figur 5a eingezeichneten Ausschnitts in Figur 5b). Andere Wände 12-14 des Gehäuses 10 können kein poröses Material tragen oder poröses Material in und/oder an den Wänden tragen. In der Öffnung ist außerdem ein gasdurchlässiger flammendurchschlagsicherer Körper 32 angeordnet. Das poröse Material ist zwischen dem flammendurchschlagsicheren Druckentlastungskörper 32 und dem Innenraum 15 des Gehäuses angeordnet, so dass das offenporige gasdurchlässige Material 31 den Druckentlastungskörper 32 gegen den Innenraum 15 vollständig jedoch gasdurchlassend abdeckt. Um durch den Druckentlastungskörper vom Innenraum 15 des Gehäuses 10 in die Umgebung des Gehäuses 10 zu treten, muss das Gas erst durch das offenporige Material 31 strömen.

Der Druckentlastungskörper 32 kann in einer Ausführungsform ohne das offenporige Material 31 dazu ausgelegt sein, Zünddurchschlagsicherheit zu gewährleisten. Insbesondere kann der Druckentlastungskörper 32 die Anforderung einer einschlägigen Norm, beispielsweise der Norm EN 60079-1, an die Abmessung der Spalte des Druckentlastungskörpers 32 für eine bestimmte Klasse, beispielsweise IIA, IIB oder IIC der Norm EN 60079-1, erfüllen, um Zünddurchschlag zu verhindern. Der Typ (Typprüfung) des Druckentlastungskörpers 32 kann ohne davor angeordnetes offenporiges Material 31 des in Figur 5a gezeigten Typs geprüft sein oder der konkrete Druckentlastungskörper 32 kann ohne den davor angeordneten in Figur 5a konkret dargestellten offenporigen Körper 31 geprüft (Stückprüfung) worden sein. Der Druckentlastungskörper 32 kann aber gezielt nicht dazu ausgelegt oder geeignet sein, ohne das davor angeordnete offenporiges Material 31 eine Temperatur der äußeren Oberfläche des Druckentlastungskörpers 32 bzw. des Gehäuses 10 zu gewährleisten, welche nicht zur thermischen Zündung eines bestimmten Gases außen am Gehäuse 10 führt. Der Druckentlastungskörper 32 kann insbesondere nicht dazu ausgelegt oder geeignet sein eine bestimmte Temperaturklasse der Norm EN/IEC 60079-0 zu erfüllen. Vielmehr ist bevorzugt die kombinierte Anordnung aus porösem Material 31 und Druckentlastungskörper 32 - in der Anordnung können das poröse Material und der Druckentlastungskörper verbunden oder nicht verbunden, sich berührend oder beabstandet sein - dazu ausgelegt, sicherzustellen, dass die Überschreitung der Oberflächentemperatur der Oberfläche des porösen Körpers 32 oder der Außenfläche des Gehäuses 10 über eine vorgegebene maximale Temperatur vermieden wird. Die Anordnung aus porösem Material 31 und Druckentlastungskörper 32 ist also bevorzugt dazu ausgelegt einer bestimmten Temperaturklasse, beispielsweise der Norm EN/IEC 60079-0, zu genügen. Insbesondere bei mit dem Druckentlastungskörper 32 verbundenem, z.B. versintertem, porösem Material 31 kann von zwei verbundenen Segmenten eines Elements gesprochen werden. Jedoch ist die Auslegung für Zünddurchschlagsicherheit in Ausführungsformen auf den Druckentlastungskörper 32 beschränkt, während erst die kombinierte Anordnung aus offenporigem Körper 31 und Druckentlastungskörper 32 für die Einhaltung der Maßgabe einer Temperaturklasse ausgelegt ist.

Einem nicht beanspruchten Verfahren entsprechend kann zum Bereitstellen einer Kombination aus einem offenporigen Material 31 und einem Druckentlastungskörper 32 der Druckentlastungskörper 32 unabhängig von dem offenporigen Material 31, insbesondere ohne Berücksichtigung offenporigen Materials 31, für Zünddurchschlagsfestigkeit (z.B. gemäß Norm EN 60079-1) ausgelegt werden, und bevorzugt geprüft werden, und eine Anordnung des offenporigen Materials 31 und des Druckentlastungskörpers 32 für das Sicherstellen des Einhaltens einer vorgegebenen Obergrenze der Temperatur des Druckentlastungskörpers 32 und/oder eines Gehäuses 10 ausgelegt werden, z.B. gemäß einer Temperaturklasse der Norm EN/IEC 60079-0. Der Druckentlastungskörper 32 alleine kann noch nicht ausreichen, um die Zieltemperaturklasse zu erreichen. Erst mit dem offenporigen Material 31 wird mit der Anordnung die Zieltemperaturklasse erreicht. Die Anordnung wird ausgelegt, die notwendige Wärmekapazität und/oder Wärmeleitfähigkeit aufzuweisen, um für eine Spitzentemperatur der Anordnung unterhalb einer vorgegebenen Maximaltemperatur auch bei Wärmeeintrag in die Anordnung auf Grund einer Explosion zu sorgen. Mittels des Verfahrens kann beispielsweise eine beliebige hierin beschriebene Anordnung eines offenporigen Materials 31 und eines Druckentlastungskörpers 32 geschaffen werden. Wenn als offenporiges Material eine Behälterstruktur enthaltend loses partikulares Material verwendet wird, wird die Auslegung der Anordnung für die erhöhte Temperaturklasse besonders einfach.

In Figur 5a und 5b sind das offenporige Material 31 und der Druckentlastungskörper 32 jeweils als Gitterstruktur mit je einer oder mehreren Gitterlagen und/oder Gitterschichten dargestellt. Unabhängig voneinander können das offenporige Material 31 und/oder der Druckentlastungskörper 32 einen von einer Gitterstruktur verschiedenen Aufbau aufweisen.

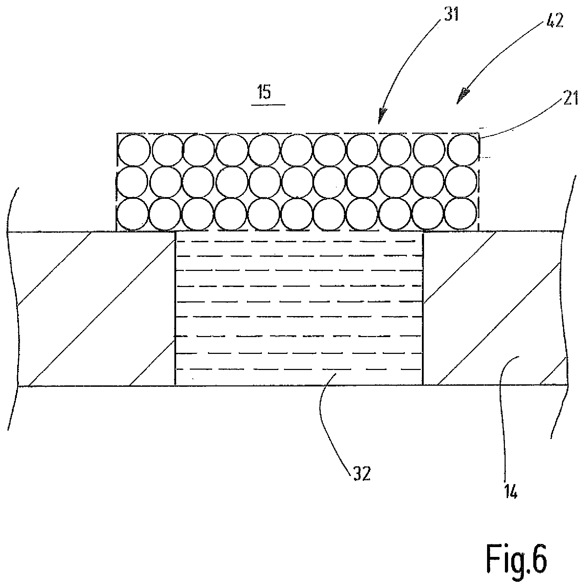

Beispielsweise zeigt Figur 6 ein Ausführungsbeispiel mit einer Behälterstruktur 41 gefüllt mit losem partikularem Material als offenporiges Material 31. Das partikulare Material kann beispielsweise eines wie im Zusammenhang mit den anderen Ausführungsformen beschrieben sein. Beispielsweise kann das lose partikulare Material ein Granulat sein, insbesondere aus Kugeln oder Körnchen aus Metall, Polymer, Glas und/oder Keramik. Die dargestellten Partikel 39 haben eine einheitliche Größe. Der gezielte Einsatz unterschiedlich großer Partikel 39 ist möglich. Das Ausführungsbeispiel gemäß Figur 6 ist gegenüber dem gemäß Figur 5a, 5b außerdem insoweit abgewandelt, als dass das offenporige Material 31 im Innenraum 15 auf der Öffnung angeordnet ist, in welcher der Druckentlastungskörper 32 angeordnet ist.

Mit dem offenporigen Material 31 kann ein Druckentlastungskörper 32 zu einer Anordnung aus dem offenporigen Material 31 und dem Druckentlastungskörper 32 ergänzt sein, welche Anforderung an Zünddurchschlagsfestigkeit und/oder Einhaltung einer maximalen Temperatur des Druckentlastungskörpers 32 und/oder des Gehäuses 10 der Druckentlastungskörper 32 alleine nicht erfüllt. Beispielsweise kann die Anordnung von offenporigem Material 31 und Druckentlastungskörper 32 eine Zünddurchschlagsfestigkeitsstufe oder - klasse erfüllen, welche Zünddurchschlagsfestigkeitsstufe oder -klasse der Druckentlastungskörper 32 ohne das offenporige Material 31 nicht einhält. Der Druckentlastungskörper 32 kann beispielsweise ausgelegt und bevorzugt geprüft sein eine bestimmte Stufe oder Klasse der Zünddurchschlagsfestigkeit, beispielsweise IIA oder IIB der Norm IEC 60079-5, einzuhalten. Die Kombination aus Druckentlastungskörper 32 und offenporigem Material 31 kann beispielsweise dazu ausgelegt sein, den Voraussetzungen einer höheren Stufe oder Klasse Zünddurchschlagsicherheit, z.B. IIB oder IIC der Norm IEC 66079-5, zu genügen.

Diese Ertüchtigung eines Druckentlastungskörpers 32 zum Erreichen einer höheren Temperatur- oder Zünddurchschlagschutzklasse kann mit in und/oder auf der Öffnung, in welcher der Druckentlastungskörper 32 angeordnet ist, erreicht werden - wie z.B. in den Figuren 1, 4, 5a,b, 6, 7 und 8 veranschaulicht.

Alternativ kann die Öffnung, die mit einem Druckentlastungskörper 32 versehen ist, frei von einem offenporigem Material 31 sein oder nur teilweise überdeckt oder gefüllt sein, wobei offenporiges Material 31 an einer anderen Stellen in dem Innenraum 15 des Gehäuses 10 (z.B. Körper 26) in Figur 1 oder an oder in einer Wand 11 - 14 des Gehäuses 10 angeordnet ist und auf Grund des offenporigen Materials eine kleinere bestimmte vorgegebene maximale Temperatur des Gehäuses 10 und/oder des Druckentlastungskörpers 32 eingehalten wird, als ohne das offenporige Material 31. Insbesondere können auf Grund des offenporigen Materials 31 die eingehaltene maximale Temperatur des Gehäuses 10 und/oder die Zünddurchschlagsicherheit um wenigstens eine Klasse (Abstufung) erhöht sein.

Nicht nur kann ein Typ eines Druckentlastungskörpers 32, welcher zum Einhalten einer bestimmten Zünddurchschlagsicherheitsstufe ausgelegt ist und welcher ggf. zusätzlich zum Einhalten einer bestimmten maximalen Oberflächentemperatur zur Vermeidung von Entzündung explosionsfähiger Atmosphäre an der äußeren Oberfläche gemäß einer Sicherheitsstufe ausgelegt ist, konstruktiv zu der Anordnung mit dem offenporigen Material 31 ergänzt werden, um eine Anordnung mit einer höhere Sicherheitsstufe der Zünddurchschlagsicherheit und/oder eine kleinere maximale Oberflächentemperatur zu schaffen. Sondern insbesondere ein bereits hergestellter und ggf. verbauter Druckentlastungskörper 32 kann vorteilhafterweise mit einem porösen Material 31 zu einer beliebigen Anordnung, wie hierin beispielhaft beschrieben, ergänzt werden. Damit ist auch ein Aufrüsten eines vorhandenen Gehäuses 10 oder eines vorhandenen Druckentlastungskörpers 32 möglich.

Ausführungsbeispielen eines Verfahrens zur Bereitstellung einer Anordnung mit erhöhter Zünddurchschlagsicherheit entsprechend, mit welchem hierin beschrieben Anordnungen mit offenporigem Material 31 und einem Druckentlastungskörper 32 bereitgestellt werden können, weisen das Anordnen eines offenporigen Materials 31 und eines zünddurchschlagsicheren Körpers 32 zu einer Anordnung auf. Die Anordnung aus zünddurchschlagsicherem Körper 32 und offenporigem Material 31 ist für eine höhere Zünddurchschlagfestigkeit ausgelegt, als der zünddurchschlagsichere Körper 32 ohne das offenporige Material 31. Der zünddurchschlagsichere Körper 32 kann ohne das offenporige Material 31 auf Zünddurchschlagsicherheit geprüft sein. Die Anordnung kann einer Prüfung auf erhöhte Zünddurchschlagsicherheit unterzogen werden.

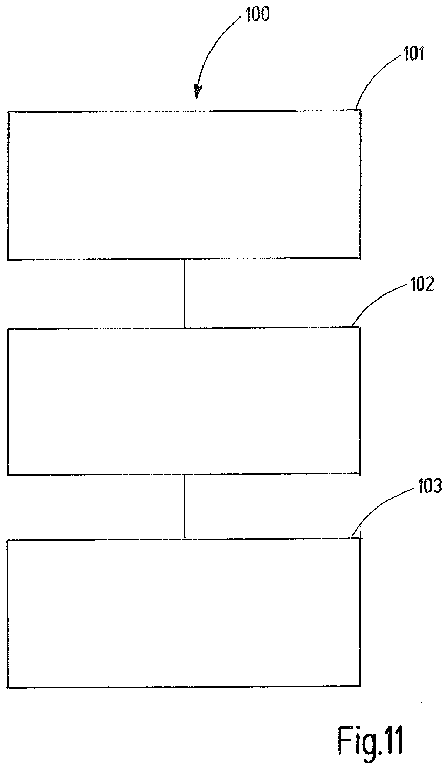

Figur 11 zeigt Verfahren 100 beispielhaft veranschaulicht, wobei in einem Schritt 101 ein Körper 32 für eine bestimmte Zünddurchschlagfestigkeit ausgelegt wird oder ein Körper 32 mit einer bestimmten Zünddurchschlagfestigkeit bereitgestellt wird. In einem weiteren Schritt 102 wird eine Anordnung des Körpers 32 und offenporigen Materials 31 für das Sicherstellen des Einhaltens einer maximalen Temperatur (z.B. gemäß einer der Temperaturklassen T1 bis T6) des flammendurchschlagsicheren Körpers 32 und/oder des Gehäuses 10, zu dessen Druckentlastung der Körper 32 dient, ausgelegt oder es wird eine Anordnung aus zünddurchschlagsicheren Körper 32 und offenporigem Material 31 für eine höhere Zünddurchschlagsicherheitsstufe ausgelegt, als der zünddurchschlagsichere Körper 32. In einem zusätzlichen Schritt 103 werden der Körper und das offenporige Material 31 zu der Anordnung angeordnet.

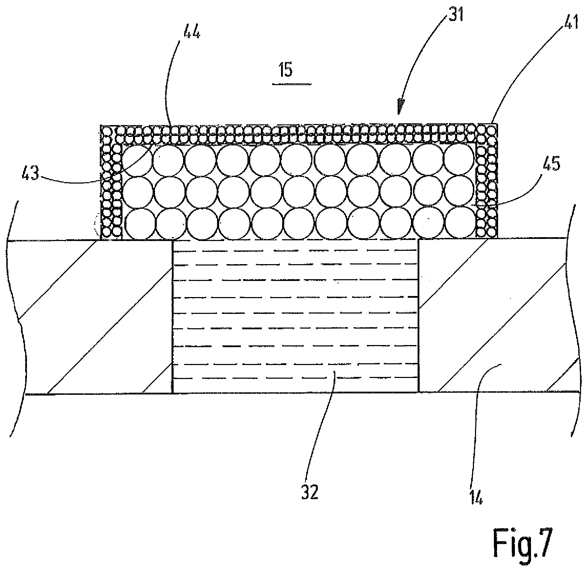

Figur 7 zeigt ein Ausführungsbeispiel eines Ausschnitts der Wand 14 entsprechend einer Ausführungsform gemäß Figur 6, wobei vor der Öffnung in der Wand 14, in dem Innenraum 15 offenporiges Material 31 angeordnet ist, so dass Gas vor dem Eintreten in den Druckentlastungskörper 32 durch das offenporige Material treten muss. Das offenporige Material 31 ist in Form einer Behälterstruktur 41 gefüllt mit losem partikularem Material bereitgestellt. Die Behälterstruktur 41 ist mittels einer gasdurchlässigen Aufteilstruktur 43 in zwei Abteile getrennt, welche mit unterschiedlich großen Partikeln gefüllt sind. Das erste Abteil, welches mit kleineren Partikeln gefüllt ist, als das zweite Abteil, deckt das zweite Abteil zum Innenraum 15 ab. Das Gas muss vom Innenraum 15 zunächst durch das erste Abteil 44, durch die Aufteilungsstruktur 43 und dann durch das zweite Abteil 45 dringen, bevor es den Druckentlastungskörper 32 erreicht. Beim Übertritt vom ersten Abteil 44 in das zweite Abteil 45 kann es auf Grund der Volumenvergrößerung des freien Volumens zwischen den Partikeln 39 in dem ersten Abteil 44 relativ zu dem zweiten Abteil 45 zu einer zusätzlichen Abkühlung heißen Explosionsgases kommen. Die Partikel in einem Abteil können sich von den Partikeln in einem andere Abteil alternativ oder zusätzlich zur Größe in einer oder mehreren anderen Eigenschaften unterscheiden, z.B. Zusammensetzung und/oder Gestalt. Die Abteile können unterschiedliche Füllgrade aufweisen.

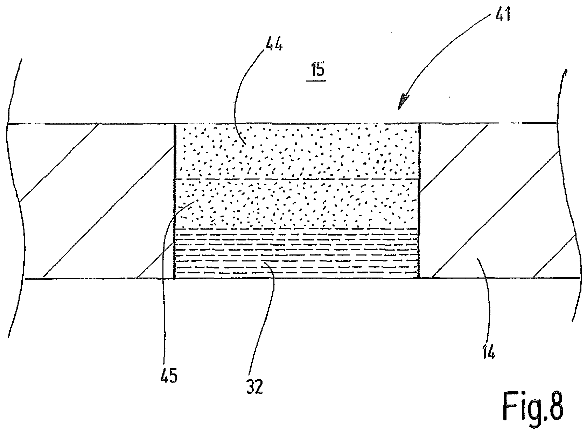

Figur 8 zeigt eine Anordnung aus einem flammendurchschlagsicheren Druckentlastungskörper 32 in einer Öffnung einer Wand 14. In der Öffnung ist zwischen dem durchschlagsicheren Druckentlastungskörper 32 und dem Innenraum 15 des Gehäuses 10 eine Behälterstruktur 41 gefüllt mit losem partikularem Material als offenporiges Material 31 angeordnet, welches den Druckentlastungskörper 32 ergänzt. Die Behälterstruktur 41 kann in zwei oder mehr Abteile 44, 45 unterteilt sein, welche vom Innenraum 15 zum Druckentlastungskörper 32 draußen nacheinander vom Gas durchströmt werden müssen.

Das erfindungsgemäße Gehäuse 10 ist zur Reduktion von internem Explosionsdruck innen mit einer wenigstens zwei Seiten des Gehäuses 10 umfassenden Auskleidung aus offenporigen Material versehen. Zusätzlich kann in dem Gehäuse ein Formkörper aus offenporigem Material angeordnet sein. Das offenporige Material kann beispielsweise gebundenes Fasermaterial oder eine Behälterstruktur 41 enthaltend loses partikulares Material sein.

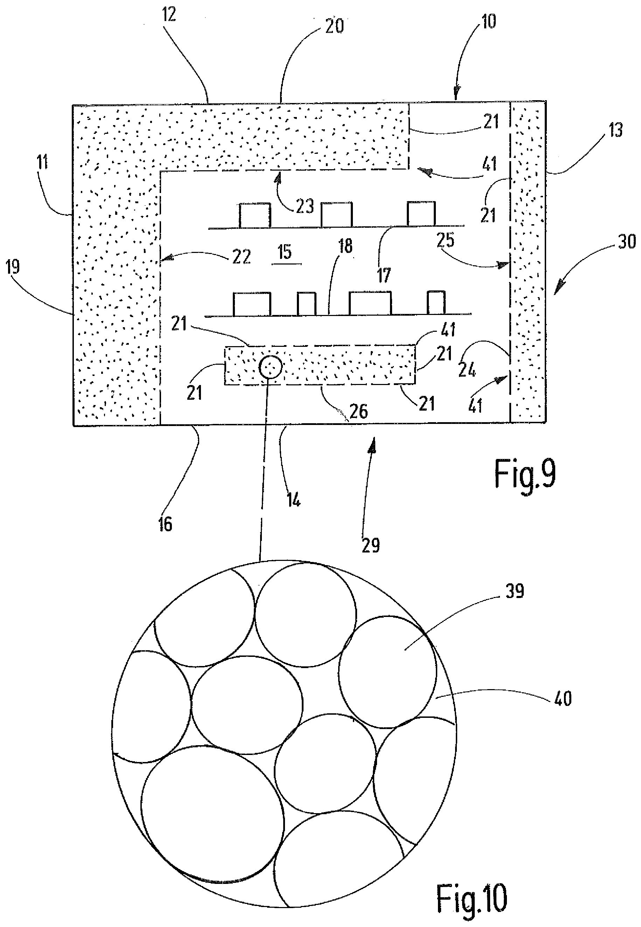

Anhand von Figur 9 sind noch weitere Ausführungsbeispiele eines erfindungsgemäßen Gehäuses 10 veranschaulicht. Das Gehäuse 10 umfasst mehrere Wänden 11, 12, 13, 14, die einen nach außen abgeschlossenen Innenraum 15 umgrenzen. Die Wände 11 bis 14 bilden zusammen mit einem nicht weiter veranschaulichten Boden und einem Deckel eine Wandanordnung 16. Boden und Deckel diese Gehäuses 10 können mit den Wänden 11 bis 14 fest oder auch lösbar verbunden sein. Sie werden weiterhin ebenfalls als Wände angesehen.

In dem Innenraum 15 können Bauelemente und Komponenten wie beispielsweise Leiterplatten, 17, 18 mit darauf angeordneten elektrischen Bauelementen angeordnet sein, die Zündquellen bilden können.

An wenigstens zwei der Wände 11, 12, 13, 14 des Gehäuses 10 ist offenporiges Material 19, 20 angeordnet, das die jeweilige Wand 11, 12 jeweils ganz oder teilweise bedeckt. Das offenporige Material 19, 20 ist von einer Behälterstruktur 41 gefüllt mit losem partikularem Material gebildet Im Zusammenhang mit anderen Figuren erläuterte Merkmale der Behälterstruktur 41 und/oder des losen partikularen Materials können optional auch auf das in dem Gehäuse 10 der anhand von Figur 9 veranschaulichten Ausführungsformen zutreffen. Zu der Behälterstruktur 41 gehört eine Begrenzungsstruktur 21, z.B. eine Gitterstruktur, welche wenigstens eine von den Wänden 11-14 des Gehäuses, welche den Innenraum 15 umgrenzen, fremde Behälterwand 21 bildet. Diese Behälterwand 21 lässt Gas in den Behälterstrukturinnenraum, welcher zumindest teilweise mit dem losen partikularen Material gefüllt und mittels der Behälterstruktur 41 von dem restlichen Innenraum 15 des Gehäuses 10 abgegrenzt ist, passieren. Die Behälterwand 21 hält jedoch die Partikel 39 (Figur 10) ab, in den zu der Behälterstruktur 41 komplementären Bereich des Innenraums 15 zu gelangen. Öffnungen in der Behälterwand 21 sind entsprechend klein dimensioniert. Die Gitterstruktur 21 kann ein Lochblechgehäuse, ein Drahtgitter, ein Käfig oder dergleichen sein.

Das lose partikulare Material kann unmittelbar an die jeweilige Wand 11, 12 anliegend angeordnet sein. Bevorzugt ist kein partikulares Material mit der Wand 11, 12 verbunden. Wenn das lose partikulare Material unmittelbar an der jeweiligen 11, 12 Wand anliegend angeordnet ist, bildet die jeweilige Wand 11, 12 einen Teil der Behälterstruktur 41. Alternativ kann die Behälterstruktur 41 ganz aus Begrenzungsstrukturen 21 zusammengesetzt sein, welche von den Wänden 11-14, die den Innenraum 15 begrenzen, verschieden sind. Diese Begrenzungsstrukturen 21 können beispielsweise einen Käfig bilden, der das offenporige Material 19, 20 von dem sonstigen Innenraum 15 fernhält und mit dem Gehäuse 10 bevorzugt verbunden ist.

Die Gitterstruktur 21 folgt den Wänden 11 und 12 und ist damit über Eck angeordnet. Allgemein kann die Gitterstruktur 21 der Gehäuseform und/oder Wandform des Gehäuses 21 angepasst sein, z.B. entlang der Wand konstanten Abstand zu der Wand 11, 12 aufweisen.

Das offenporige Material 19, 20 weist an seiner jeweils zu dem Innenraum 15 hin weisenden Seite Flächen 22, 23 auf, die wie dargestellt in einem Winkel zueinander angeordnet sind, der kleiner als 180° ist.

Zusätzlich zu dem offenporigen Material 19, 20 ist dem offenporigen Material 19 gegenüberliegend ein weiterer Abschnitt 24 offenporigen Materials angeordnet. Dieses kann das gleiche oder ein anderes offenporiges Material wie die Materialien 19, 20 sein. Es kann also ebenso von einer Behälterstruktur 41 mit einer Begrenzungsstruktur 21 gefüllt mit losem partikularem Material gebildet sein. Es kann die gleiche oder eine unterschiedliche Dicke aufweisen. Ebenso können die offenporigen Materialien 19, 20 gleiche oder unterschiedliche Dicken aufweisen. Das Material 24 weist eine dem Innenraum 15 zugewandte Fläche 25 auf, die der Fläche 22 gegenüberliegt und die zu der Fläche 23 im Winkel von z.B. 90° angeordnet ist.

Das offenporige Material 19, 20 und/oder 24 bildet eine innere Druckentlastungsvorrichtung. Eine zusätzliche oder alternative innere Druckentlastungsvorrichtung kann durch einen offenporigen Körper 26 gebildet sein, wie er in Figur 9 beispielhaft veranschaulicht ist, der an wenigstens vier, vorzugsweise an fünf oder sechs Seiten frei, d.h. nicht an einer der Wände der Wandanordnung anliegend, in dem Innenraum 15 des Gehäuses 10 angeordnet ist. Für den offenporigen Körper 26 gilt bevorzugt, dass dieser, wie in Figur 9 beispielhaft veranschaulicht, an wenigstens vier, vorzugsweise an fünf oder sechs Seiten nicht an je einer Wand angeordnet ist. Bevorzugt sind zwischen dem Körper 26 und wenigstens vier Wänden jeweils Einbaubereiche vorgesehen, in welche elektrische Bauelemente, elektrische Schaltungen oder sonstige elektrische Betriebsmittel einbaubar oder eingebaut sind, welche Zündquellen bilden können. Der Körper 26 kann insbesondere von elektrischen Bauelementen, elektrische Schaltungen oder sonstigen elektrische Betriebsmitteln umgeben sein. Der Körper 26 ist bevorzugt durch alle freien Seiten gasdurchlässig. Die nachfolgenden Erläuterungen des Körpers 26 gelten optional auch für das offenporige Material 19, 20, 24.

Der Körper 26 ist, wie in Figur 9 veranschaulicht, aus einer Behälterstruktur 41 gebildet, welche mit losem partikularem Material teilweise gefüllt ist. Die gasdurchlässigen Begrenzungsstrukturen 21 der Behälterstruktur 41 trennt ein Abteil des Innenraums 15 für die Füllung aus losem partikularem Material ab. Damit kann beispielsweise eine Kugelschüttung an einem beliebigen Ort in dem Gehäuse 10 platziert werden. Das lose partikulare Material kann beispielsweise Quarzsand oder Glaspartikel sein. Die Behälterstruktur 41 kann als Füllung beispielsweise eine homogene Mischung von Partikeln 39, welche hinsichtlich Form, Größe und/oder Zusammensetzung uneinheitlich sein können, oder Partikel 39 einheitlicher Größe, Form und Zusammensetzung enthalten. Der Körper 26 ist vorzugsweise frei von elektrischen Betriebsmitteln, insbesondere frei von elektrischen Bauteilen. Der Körper 26 selbst weist Spalte auf, welche nicht zünddurchschlagsicher sein zu brauchen. Die Spalte gebildet durch Öffnungen in der Behälterstruktur 41 sowie Zwischenräumen zwischen Partikeln der Füllung aus losem partikularem Material müssen kein Normmaß aufweisen, so dass Zünddurchschlagsicherheit durch die Spalte sichergestellt ist. Der Körper 26 dient allein dem Druckabbau bei einer auftretenden Explosion im Innenraum 15 des Gehäuses 10. Das Gehäuse 10, welches den Körper 26 und/oder das poröse Material 19, 20, 24 aufweist, braucht der Zündschutzart "Sandkapselung" (Ex-q, gemäß der Norm IEC 60079-5) nicht zu entsprechen. In dem Körper 26 können sich die losen Partikel auf Grund des Füllgrades noch gegeneinander bewegen.

Es können zwei oder mehr Körper 26 in dem Gehäuse 10 angeordnet sein.

Im Falle einer Explosion, welche von einer Zündquelle zwischen einer Seite des Körpers 26 und der gegenüberliegenden Wand 11, 12, 13 oder 14 ausgeht, kann die Druckwelle einerseits direkt auf den porösen Körper 26 treffen und durch Öffnungen in der Begrenzungsstruktur 41, z.B. eine Käfigseite, hindurch in die Schüttung aus porösem Material eintreten. Die kinetische Energie wird dabei in Verformungs- und/oder Bewegungsenergie der losen Partikel umgesetzt. Diese geben die Partikel durch Stöße und Reibung an andere Partikel 36 und die Behälterstruktur 41 weiter, um diese in dem porösen Körper 26 zu verteilen. Die Druckwelle kann andererseits an der gegenüberliegenden Wand 11, 12, 13 oder 14, insbesondere, wenn diese frei von porösem Material ist, oder dem porösen Material an der Wand 11, 12, 13 oder 14, zu dem porösen Körper 26 und/oder einer der Wand gegenüberliegenden Wand und/oder einer in einem Winkel angeordneten Wand reflektiert werden. Auch diese Wand bzw. Wände können frei von porösem Material sein oder mit porösem Material versehen sein. Von der Wand oder dem porösen Material kann die Druckwelle zu einer anderen Seite des porösen Körpers 26 reflektiert werden, um dort zumindest teilweise absorbiert zu werden. Die Druckwelle kann, auch wenn die Zündquelle zwischen einer bestimmten Seite des porösen Körpers 26 und einer gegenüberliegenden Wand liegt, trotzdem durch Reflektion an den Wänden 11-14 und/oder porösem Material auf alle zugänglichen Seiten des porösen Körpers 26 treffen und von diesem absorbiert werden. Die Schüttung aus losem partikularem Material ist also solche gestaltlos, womit eine starke Richtungsabhängigkeit auf Grund der Füllung der Behälterstruktur 41 mit der Schüttung bei der Aufnahme von kinetischer Energie und/oder Wärmeenergie auf Grund der Druckwelle durch den porösen Körper 26 vermieden wird. Die Form der Behälterstruktur 41 und/oder die Form, die die Behälterstruktur 41 der Füllung verleiht, ist bevorzugt rotationssymmetrisch von der Ordnung von Vielfachen von vier oder nicht-diskret rotationssymmetrisch, so dass die Seiten des porösen Körpers 26 bzw. der Füllung, die den Wänden 11 - 14 gezeigt werden, von vergleichbarer Größe und Form sind. Der Körper 26 kann insbesondere zentral zwischen vier in Figur 9 dargestellten Wänden 11 - 14 angeordnet sein, welche abweichend von der in Figur 9 dargestellten Ausführungsform frei von porösem Material 19, 20, 24 sein können.

Das Gehäuse 10 ist nicht mit einer Druckentlastungsvorrichtung 29 und/oder 30 versehen, die eine Strömungsverbindung zwischen dem Gehäuseinnenraum und der Umgebung ermöglicht. Solche, in dem Gehäuse 10 gemäß Figur 9 fehlende Druckentlastungsvorrichtungen 29, 30, 32 sind im Zusammenhang mit anderen Ausführungsformen der Erfindung als poröse gasdurchlässige Körper mit einer Spaltweite und Spaltlänge, die einen Flammendurchschlag (Zünddurchschlag) verhindert, beschrieben (s. Figuren 1, 4, 5a, 5b, 6, 7, 8). Das Gehäuse 10 kann vielmehr druckdicht sein.

Das Gehäuse 10 gemäß Figur 9 kann ähnlich zu dem Gehäuse gemäß Figur 3 gestaltet sein und poröses Material in Form von einer oder mehreren Behälterstrukturen 41 gefüllt mit losem partikularem Material an allen vier Wänden 11, 12, 13, 14 des Gehäuses 10 und optional zusätzlich an dem nicht veranschaulichten Boden und/oder dem Deckel aufweisen.

Das offenporige Material der Ausführungsformen, wie im Zusammenhang mit den Figuren 9 und 10 erläutert, bildet eine an den Wänden entlang führende lokal unterbrochene oder auch ununterbrochene Schicht und/oder einen Körper 26, die bzw. der eine in dem Innenraum 15 gezündete Flammenfront auffängt und die entstehende Druckwelle absorbiert.

### Bezugszeichen:

| | |
|---|---|
| 10 | Gehäuse |
| 11 - 14 | Wände |
| 15 | Innenraum |
| 16 | Wandanordnung |
| 17, 18 | Leiterplatten, elektrisches Betriebsmittel |
| 19, 20 | offenporiges Material |
| 21 | Gitterstruktur/Begrenzungsstruktur |
| 22, 23 | Flächen des offenporigen Materials |
| 24 | Abschnitt des offenporigen Materials |
| 25 | Fläche |
| 26 | offenporiger Körper |
| 27 | Fasern |
| 28 | Bindemittel |
| 29, 30 | Druckentlastungsvorrichtung |
| 31 | offenporiges Material |
| 32 | Druckentlastungskörper |
| 33 | Expansionsvolumen |
| 34 | Teilgehäuse |
| 35 | Druckentlastungskörper |
| 36 | Durchführungseinrichtung |
| 37 | Welle |
| 38 | Spalt |
| 39 | Partikel eines losen partikularen Materials |
| 40 | Pore |
| 41 | Behälterstruktur |
| 42 | weitere Begrenzungsstruktur |
| 43 | Aufteilungsstruktur |
| 44 | Erstes Abteil |
| 45 | Zweites Abteil |

## Patentansprüche

1. Gehäuse (10), insbesondere Gehäuse der Schutzart druckfeste Kapselung
mit einer Wandanordnung (16), die mehrere Wände (11, 12, 13, 14) aufweist, die einen nach außen abgeschlossenen Innenraum (15) umschließen, wobei wenigstens zwei der Wände (11, 12) mit einem offenporigen Material (19, 20, 31) versehen sind, indem dieses an den Wänden (11, 12, 13, 14) angebracht ist,
**dadurch gekennzeichnet, dass** das offenporige Material (19, 20, 31) loses partikulares Material in einer gasdurchlässigen Behälterstruktur (41) ist,
wobei die Behälterstruktur (41) eine maximale Menge des Schüttguts fassen kann, wobei die Behälterstruktur (41) weniger als die maximale Menge des losen partikularen Materials enthält, so dass sich die Partikel des losen partikularen Materials noch gegeneinander bewegen können.

2. Gehäuse (10) nach Anspruch 1, **dadurch gekennzeichnet, dass** der das offenporige Material (19, 20, 31) tragende Bereich der Wand (11, 12, 13, 14) wenigstens eine Öffnung aufweist, die mit einem gasdurchlässigen flammendurchschlagsicheren Körper (32) versehen ist.

3. Gehäuse (10) nach einem der vorstehenden Ansprüche, wobei das offenporige Material (19, 20, 31) vor dem flammendurchschlagsicheren Körper (32, 35) angeordnet ist, vorzugsweise in der Öffnung in der Wand, so dass die Explosionsfront zunächst durch das offenporige Material (19, 20, 31) treten muss, bevor die Explosionsfront durch den flammendurchschlagsicheren Körper (32) tritt.

4. Gehäuse (10) nach einem der vorstehenden Ansprüche, wobei die Anordnung mit dem porösen Material (31) und dem flammendurchschlagsicheren Körper (32) dazu ausgelegt ist, dass deren maximale Oberflächentemperatur und/oder die maximale Temperatur des Gehäuses (10) mit Hilfe des porösen Materials (31) unterhalb einer festgelegten Temperatur bleibt, wobei das poröse Material (31) allein nicht dazu ausgelegt ist, zünddurchschlagsicher zu sein.

5. Gehäuse (10) nach einem der vorstehenden Ansprüche, wobei die Kombination aus flammendurchschlagsicherem Körper (32, 35) mit dem davor angeordneten offenporigen Material (19, 20, 31) eine höhere Zünddurchschlagsschutzklasse als der flammendurchschlagsichere Körper (32, 35) aufweist.

6. Gehäuse (10) nach einem der vorstehenden Ansprüche, wobei das offenporige Material (19, 20, 31) mit dem flammendurchschlagsicheren Körper (32, 35) zu einem Element verbunden ist.

7. Gehäuse (10) nach einem der vorstehenden Ansprüche, **dadurch gekennzeichnet, dass** der das offenporige Material (19, 20) tragende Bereich der Wand (11, 21) geschlossen ausgebildet ist oder lediglich flammendurchschlagsichere Spalte (38) aufweist.

## Claims

1. A housing (10), in particular a housing of the ignition protection type flameproof enclosure,
having a wall arrangement (16) comprising a plurality of walls (11, 12, 13, 14) which enclose inner space (15) that is closed to the outside, wherein at least two of the walls (11, 12) are provided with an open-pore material (19, 20, 31) in that the latter is attached to the walls (11, 12, 13, 14),
**characterized in that** the open-pore material (19, 20, 31) is bulk particulate material in a gas-permeable container structure (41),
wherein the container structure (41) is able to contain a maximum amount of the bulk material, wherein the container structure (41) contains less than the maximum amount of the bulk particulate material, so that the particles of the bulk particulate material can still move relative to each other.

2. The housing (10) according to claim 1, **characterized in that** the area of the wall (11, 12, 13, 14) supporting the open-pore material (19, 20, 31) comprises at least one opening which is provided with a gas-permeable flameproof body (32).

3. The housing (10) according to anyone of the preceding claims, wherein the open-pore material (19, 20, 31) is arranged in front of the flameproof body (32, 35), preferably in the opening in the wall, such that the explosion front must first pass through the open-pore material (19, 20, 31) before the explosion front passes through the flameproof body (32).

4. The housing (10) according to anyone of the preceding claims, wherein the arrangement comprising the porous material (31) and the flameproof body (32) is configured such that its maximum surface temperature and/or the maximum temperature of housing (10) remains below a predefined temperature by means of the porous material (31), wherein the porous material (31) alone is not configured to be flameproof.

5. The housing (10) according to anyone of the preceding claims, wherein the combination of the flameproof body (32, 35) with the open-pore material (19, 20, 31) arranged in front thereof has a higher flameproof protection class than the flameproof body (32, 35).

6. The housing (10) according to anyone of the preceding claims, wherein the open-pore material (19, 20, 31) is connected to the flameproof body (32, 35) to form one element.

7. The housing (10) according to anyone of the preceding claims, **characterized in that** the area of the wall (11, 21) supporting the open-pore material (19, 20) is configured in a closed manner or has only flameproof gaps (38).

## Revendications

1. Boîtier (10), en particulier boîtier du type de protection « blindage résistant à la pression »,
comprenant un agencement de parois (16) qui comporte plusieurs parois (11, 12, 13, 14) entourant un espace intérieur (15) fermé vis-à-vis de l'extérieur, au moins deux des parois (11, 12) étant pourvues d'un matériau à pores ouverts (19, 20, 31), par le fait que celui-ci est fixé aux parois (11, 12, 13, 14),
**caractérisé en ce que** le matériau à pores ouverts (19, 20, 31) est un matériau particulaire en vrac dans une structure de récipient (41) perméable au gaz,
la structure de récipient (41) pouvant contenir une quantité maximale du produit en vrac, la structure de récipient (41) contenant une quantité moindre que la quantité maximale du matériau particulaire en vrac, de manière à ce que les particules du matériau particulaire en vrac puissent encore se déplacer les unes par rapport aux autres.

2. Boîtier (10) selon la revendication 1, **caractérisé en ce que** la partie de la paroi (11, 12, 13, 14) portant le matériau à pores ouverts (19, 20, 31) présente au moins une ouverture qui est pourvue d'un corps (32) perméable au gaz, résistant au passage des flammes.

3. Boîtier (10) selon une des revendications précédentes, dans lequel le matériau à pores ouverts (19, 20, 31) est disposé devant le corps (32, 35) résistant au passage des flammes, de préférence dans l'ouverture dans la paroi, de manière à ce que le front de l'explosion doive d'abord traverser le matériau à pores ouverts (19, 20, 31), avant que le front de l'explosion ne traverse le corps (32, 35) résistant au passage des flammes.

4. Boîtier (10) selon une des revendications précédentes, dans lequel l'agencement comportant le matériau (31) poreux et le corps (32) résistant au passage des flammes est conçu pour que leur température de surface maximale et/ou la température maximale du boîtier (10) reste en dessous d'une température définie grâce au matériau (31) poreux, le matériau (31) poreux à lui seul n'étant pas conçu pour être antidéflagrant.

5. Boîtier (10) selon une des revendications précédentes, dans lequel la combinaison du corps (32, 35) résistant au passage des flammes avec le matériau à pores ouverts (19, 20, 31) disposé devant celui-ci, présente une classe de protection antidéflagrante plus élevée que le corps (32) résistant au passage des flammes.

6. Boîtier (10) selon une des revendications précédentes, dans lequel le matériau à pores ouverts (19, 20, 31) est relié au corps (32, 35) résistant au passage des flammes pour former un élément.

7. Boîtier (10) selon une des revendications précédentes, **caractérisé en ce que** la partie de la paroi (11, 21) portant le matériau à pores ouverts (19, 20) est réalisée sous une forme fermée ou présente seulement des fentes (38) résistant au passage des flammes.
